# EUROPEAN PATENT APPLICATION

(11) **EP 4 432 348 A1**
(43) Date of publication of application: **18.09.2024**
(21) Application number: 23161841.4
(22) Date of filing: 14.03.2023
(51) Int. Cl.: H01L 23/495, H01L 23/00

(54) **POWER SEMICONDUCTOR PACKAGE COMPRISING A PASSIVE ELECTRONIC COMPONENT AND METHOD FOR FABRICATING THE SAME**

(71) Applicant: Infineon Technologies Austria AG, 9500 Villach (AT)
(72) Inventor: TAN, Joon Shyan, 70300 Seremban (MY); WANG, Lee Shuang, 75450 Bukit Baru (MY); KASSIM, Azlina, 75250 Cheng (MY); LEE, Teck Sim, 76450 Paya Rumput (MY); CHUA, Kok Yau, 75050 Melaka (MY); LEE, Chee Hong, 76450 Paya Rumput (MY); YUAN, Zhihui, 9500 Villach (AT)
(74) Representative: Lambsdorff & Lange Patentanwälte Partnerschaft mbB

(57) **Abstract**

A power semiconductor package comprises: a first power semiconductor die arranged on and electrically coupled to a first side of a first die pad, a first passive electronic component comprising a first end and an opposite second end, wherein the first end is arranged on and coupled to the first side of the first die pad and the second end is coupled to an internal ledge of a first external contact, a second passive electronic component connected in series with the first passive electronic component, and an encapsulation encapsulating the first power semiconductor die and the first and second passive electronic components, wherein the first external contact is exposed from a first lateral side of the encapsulation.

## Description

### TECHNICAL FIELD

This disclosure relates in general to a power semiconductor package, in particular a power semiconductor package comprising a passive electronic component, as well as to a method for fabricating such a power semiconductor package.

### BACKGROUND

A power semiconductor package may provide an electrical circuit like for example a half-bridge circuit, a converter circuit, an inverter circuit, etc. Such electrical circuits may be realized using one or more power semiconductor dies comprised in the power semiconductor package. However, such electrical circuits may not only comprise active electronic components like power transistors and/or diodes but may also comprise passive electronic components, for example capacitors and/or resistors. Providing the passive electronic components outside of the package, e.g. on a printed circuit board (PCB), as a separate component may cause increased leakage inductance and/or excessive voltage spikes in the electrical circuit. Furthermore, additional steps in the assembly process are required which may increase complexity and costs. On the other hand, conventional power semiconductor packages may provide only limited space for attaching passive electronic components onto lead posts. Improved power semiconductor packages and improved methods for fabricating power semiconductor packages may help in solving these and other problems.

The problem on which the invention is based is solved by the features of the independent claims. Further advantageous examples are described in the dependent claims.

### SUMMARY

Various aspects pertain to a power semiconductor package, comprising: a first power semiconductor die arranged on and electrically coupled to a first side of a first die pad, a first passive electronic component comprising a first end and an opposite second end, wherein the first end is arranged on and coupled to the first side of the first die pad and the second end is coupled to an internal ledge of a first external contact, a second passive electronic component connected in series with the first passive electronic component, and an encapsulation encapsulating the first power semiconductor die and the first and second passive electronic components, wherein the first external contact is exposed from a first lateral side of the encapsulation.

Various aspects pertain to a method for fabricating a power semiconductor package, the method comprising: arranging a first power semiconductor die on a first side of a first die pad and electrically coupling the first semiconductor die to the first side of the first die pad, providing a first passive electronic component comprising a first end and an opposite second end such that the first end is arranged on and coupled to the first side of the first die pad and the second end is coupled to an internal ledge of a first external contact, connecting a second passive electronic component in series with the first passive electronic component, and encapsulating the first power semiconductor die and the first and second passive electronic components with an encapsulation such that the first external contact is exposed from a first lateral side of the encapsulation.

### BRIEF DESCRIPTION OF THE DRAWINGS

The accompanying drawings illustrate examples and together with the description serve to explain principles of the disclosure. Other examples and many of the intended advantages of the disclosure will be readily appreciated in view of the following detailed description. The elements of the drawings are not necessarily to scale relative to each other. Identical reference numerals designate corresponding similar parts.
Figure 1 shows a plan view of a power semiconductor package, wherein a passive electronic component is directly attached to a die pad.
Figure 2 shows a plan view of a further power semiconductor package which comprises two power semiconductor dies and a passive electronic component that is directly attached to a die pad.
Figure 3 shows a plan view of a further power semiconductor package comprising two power semiconductor dies and three passive electronic components.
Figure 4 shows a side view of the power semiconductor package of Fig. 3.
Figure 5 is a flow chart of an exemplary method for fabricating power semiconductor packages.

### DETAILED DESCRIPTION

In the following detailed description, directional terminology such as "top", "bottom", "left", "right", "upper", "lower", etc. is used with reference to the orientation of the Figure(s) being described. Because components of the disclosure can be positioned in a number of different orientations, the directional terminology is used for purposes of illustration only. It is to be understood that other examples may be utilized and structural or logical changes may be made.

In addition, while a particular feature or aspect of an example may be disclosed with respect to only one of several implementations, such feature or aspect may be combined with one or more other features or aspects of the other implementations as may be desired and advantageous for any given or particular application, unless specifically noted otherwise or unless technically restricted. Furthermore, to the extent that the terms "include", "have", "with" or other variants thereof are used in either the detailed description or the claims, such terms are intended to be inclusive in a manner similar to the term "comprise". The terms "coupled" and "connected", along with derivatives thereof may be used. It should be understood that these terms may be used to indicate that two elements cooperate or interact with each other regardless whether they are in direct physical or electrical contact, or they are not in direct contact with each other; intervening elements or layers may be provided between the "bonded", "attached", or "connected" elements. However, it is also possible that the "bonded", "attached", or "connected" elements are in direct contact with each other. Also, the term "exemplary" is merely meant as an example, rather than the best or optimal.

The examples of a power semiconductor package described below may use various types of semiconductor dies or circuits incorporated in the semiconductor dies, among them AC/DC or DC/DC converter circuits, inverter circuits, power MOSFETs, power Schottky diodes, JFETs (Junction Gate Field Effect Transistors), power bipolar transistors, power integrated circuits, etc. The examples may also use semiconductor dies comprising MOS transistor structures or vertical transistor structures like, for example, IGBT (Insulated Gate Bipolar Transistor) structures or, in general, transistor structures in which at least one electrical terminal is arranged on a first main face of the semiconductor die and at least one other electrical terminal is arranged on a second main face of the semiconductor die, opposite to the first main face of the semiconductor die.

The semiconductor die(s) can be manufactured from specific semiconductor material, for example Si, SiC, SiGe, GaAs, GaN, or from any other suitable semiconductor material, and, furthermore, may contain one or more of inorganic and organic materials that are not semiconductors, such as for example insulators, plastics or metals.

The semiconductor die(s) may be covered with an encapsulation material. The encapsulation material may be electrically insulating. The encapsulation material may comprise or be made of any appropriate plastic or polymer material and may e.g. contain filler materials. Various techniques may be employed to encapsulate the semiconductor die(s) with the encapsulation material, for example compression molding, injection molding, powder molding, liquid molding or lamination. Heat and/or pressure may be used to apply the encapsulation material.

An efficient power semiconductor package and an efficient method for fabricating a power semiconductor package may for example reduce material consumption, ohmic losses, chemical waste, etc. and may thus enable energy and/or resource savings. Improved power semiconductor packages and improved methods for fabricating a power semiconductor package, as specified in this description, may thus at least indirectly contribute to green technology solutions, i.e. climate-friendly solutions providing a mitigation of energy and/or resource use.

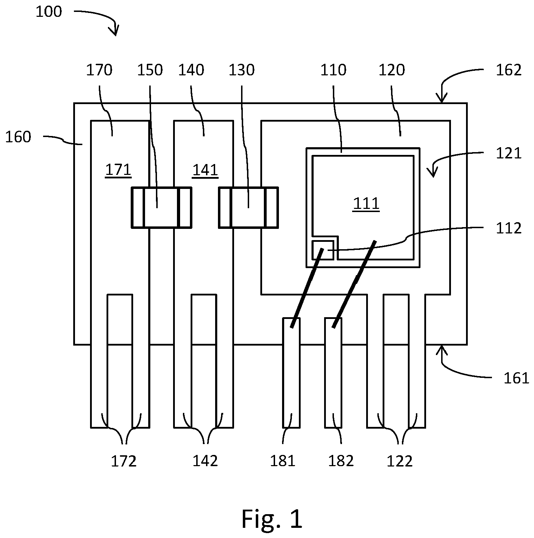

Figure 1 shows a power semiconductor package 100 comprising a first power semiconductor die 110, a first die pad 120, a first passive electronic component 130, a first external contact 140, a second passive electronic component 150 and an encapsulation 160.

The first power semiconductor die 110 is arranged over a first side 121 of the first die pad 120. The first power semiconductor die 110 may be configured to operate with a high voltage, e.g. a voltage of about 100V or more, or about 500V or more, or about 1kV or more, or about 1.2kV or more. The first power semiconductor die 110 may e.g. comprise a power transistor, in particular a vertical power transistor.

The first power semiconductor die 110 may comprise a first power terminal 111 arranged on a first side, wherein the first side of the first power semiconductor die 110 faces away from the first side 121 of the first die pad 120. The first power semiconductor die 110 may comprise a second power terminal arranged on a second side, wherein the second side of the first power semiconductor die 110 faces the first side 121 of the first die pad 120. The second power terminal may be electrically connected to the first side 121 of the first die pad 120.

According to an example, the first power terminal 111 is a drain terminal, respectively a collector terminal and the second power terminal is a source terminal, respectively an emitter terminal. According to another example, it is the other way around. The first power semiconductor die 110 may furthermore comprise a control terminal 112 which may e.g. be arranged on the first side of the first power semiconductor die 110. The control terminal 112 may e.g. be a gate terminal.

According to an example, one or more leads 122 may be connected to the first die pad 120. In particular, the one or more leads 122 and the first die pad 120 may be a monobloc part. The one or more leads 122 may be electrically connected to the second power terminal of the power semiconductor die 110.

According to an example, the power semiconductor package 100 may comprise further leads 181, 182 which may be connected to the first power terminal 111 and to the control terminal 112 of the first power semiconductor die, respectively. The lead 181 which may be connected to the control terminal 112 may for example be configured to receive control signals and the lead 182 which may be connected to the first power terminal 111 may for example be configured to provide voltage sensing.

The first passive electronic component 130 comprises a first end and an opposite second end, wherein the first end is arranged on and coupled to the first side 121 of the first die pad 120 and the second end is coupled to an internal ledge 141 of a first external contact 140. The first end being "arranged on the first side 121" may mean that the first passive electronic component 130 partially overlaps with the first side 121 of the fist die pad 120 and protrudes from the contour of the first die pad 120. The ends of the first passive electronic component 130 may for example be soldered, sintered or glued with conductive glue onto the first die pad 120 and the internal ledge 141, respectively.

The internal ledge 141 of the first external contact 140 may be configured as a mounting pad for the second end of the first passive electronic component 130. The internal ledge 141 may for example have an essentially rectangular shape as shown in Fig. 1. The first external contact 140 may furthermore comprise one or more leads 142 protruding from the internal ledge 141. The one or more leads 142 may e.g. protrude from a shorter edge of a rectangular internal ledge 141. A longer edge of a rectangular internal ledge 141 may be essentially parallel to an edge of the first die pad 120 that is opposite to the longer side. The longer edge of the internal ledge 141 may for example be about as long as or longer than the opposite edge of the first die pad 120. The longer edge of the internal ledge 141 may for example run along the whole length of the opposite edge of the first die pad 120. In this way, the internal ledge 141 may e.g. provide sufficient mounting space for both passive electronic components 130, 150.

The first passive electronic component 130 may for example be a capacitor, wherein the first end of the first passive electronic component comprises a first contact of the capacitor and the second end comprises a second contact of the capacitor. The capacitor may for example have a capacitance in the range of 5nH to 20nH, e.g. about 10nH. According to another example, the first passive electronic component is a resistor. The resistor may for example have a resistance in the range of 5Ω to 20Ω, e.g. about 10Ω.

The internal ledge 141 of the first external contact 140 may be separated from the first die pad 120 by a first trench. Furthermore, the first passive electronic component 130 may span the first trench. The first trench may for example be filled with electrically insulating material, e.g. material of the encapsulation 160.

The second passive electronic component 150 is connected in series with the first passive electronic component 130. The second passive electronic component 150 may for example be a capacitor or a resistor. The capacitor, respectively the resistor may e.g. have a capacitance, respectively a resistance as described further above with respect to the first passive electronic component 130. According to an example, the first and second passive electronic components 130, 150 are the same type of component. According to another example, the first and second passive electronic components 130, 150 are different types of components.

The second passive electronic component 150 may for example comprise a first end coupled to the internal ledge 141 of the first external contact 140 and an opposite second end coupled to an internal ledge 171 of a second external contact 170. The second external contact 170 may further comprise one or more leads 172 protruding from the internal ledge 171.

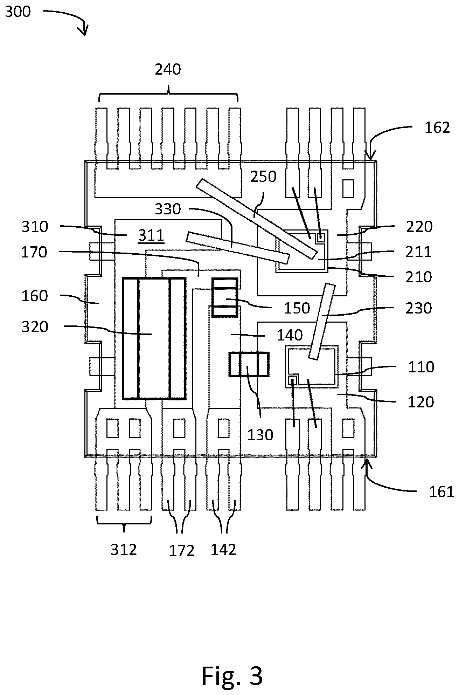

The second external contact 170 may for example have a similar or identical shape as the first external contact 140. However, it is also possible that the second external contact 170 has a different shape. For example, the internal ledge 171 of the second external contact 170 may essentially have an L-shape as described further below with respect to Fig. 3. The internal ledge 171 of the second external contact 170 may be separated from the internal ledge 141 of the first external contact 140 by a second trench. The second trench may be filled by material of the encapsulation 160. The second passive electronic component 150 may span the second trench.

By integrating the passive electronic components 130, 150 into the power semiconductor package 100, a leakage inductance and/or an excessive voltage spike may be reduced compared to the case that the passive electronic components 130, 150 are provided outside the power semiconductor package (i.e. the power semiconductor package and the passive electronic components are arranged on and coupled to a PCB) . By reducing the leakage inductance and/or the excessive voltage spike, a switching performance of the electrical circuit of the power semiconductor package 100 (e.g. a half-bridge circuit) may be improved.

The first die pad 120, the first external contact 140, the second external contact 170 and the leads 181, 182 may for example comprise or consist of Al or Cu. The first die pad 120, the first external contact 140, the second external contact 170 and the leads 181, 182 may for example be leadframe parts and may in particular be parts of the same leadframe.

The power semiconductor package 100 may comprise further components not shown in Fig. 1. For example, the power semiconductor package 100 may comprise one or more further power semiconductor dies, one or more further die pads and one or more further external contacts. The power semiconductor dies, the die pads and the external contacts may be electrically connected to form any suitable electrical circuit, e.g. a half-bridge circuit, an inverter circuit, a converter circuit, etc. Examples of such power semiconductor packages with further components are described further below.

The encapsulation 160 encapsulates the first power semiconductor die 110 and the first and second passive electronic components 130, 150. Furthermore, the first external contact 140 (in particular, the one or more leads 142 of the first external contact 140) is exposed from a first lateral side 161 of the encapsulation 160. The second external contact 170 (in particular, the one or more leads 172 of the second external contact 170) and the leads 122, 181 and 182 may also be exposed from the first lateral side 161 of the encapsulation 160.

The first passive electronic component 130 may for example be arranged at an edge of the first die pad 120 which is essentially arranged perpendicular to the first lateral side 161 of the encapsulation 160 (compare Fig. 1). The reason for this may be that the edge of the first die pad 120 which faces the first lateral side 161 of the encapsulation 160 may provide less space for mounting the first passive electronic component 130 than this edge.

The encapsulation 160 may for example comprise or consist of a molded body. The molded body may comprise any suitable mold material. The molded body may furthermore comprise inorganic filler particles configured to reduce the thermal resistance of the molded body.

According to an example, the power semiconductor package 100 comprises further leads that are exposed from the encapsulation 160 at a second lateral side 162 (not shown in Fig. 1). The second lateral side 162 may for example be opposite to the first lateral side 161.

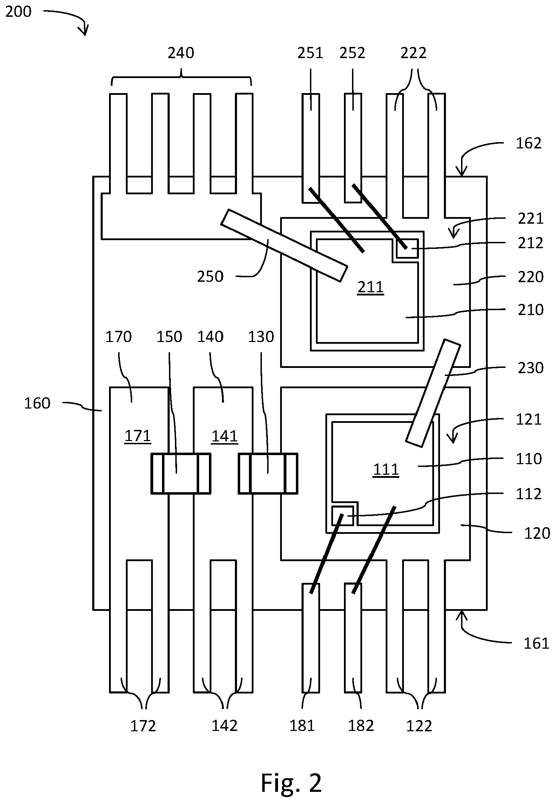

Figure 2 shows a further power semiconductor package 200 which may be similar or identical to the power semiconductor package 100, except for the differences described in the following.

In particular, the power semiconductor package 200 comprises a second power semiconductor die 210 which may for example be arranged over a first side 221 of a second die pad 220. The second power semiconductor die 210 may for example be a similar or identical type of die as the first power semiconductor die 110. However, it is also possible that the second power semiconductor die 210 is a different type of die. The first and second power semiconductor dies 110, 210 may be electrically connected to form an electrical circuit, e.g. a half-bridge circuit. In the latter case, the first power semiconductor die 110 may comprise a low side switch and the second power semiconductor die 210 may e.g. comprise a high side switch of the half-bridge circuit, or vice versa.

The second power semiconductor die 210 may comprise a first power terminal 211 arranged on a first side, wherein the first side of the second power semiconductor die 210 faces away from the first side 221 of the second die pad 220. The second power semiconductor die 210 may comprise a second power terminal arranged on a second side, wherein the second side of the second power semiconductor die 210 faces the first side 221 of the second die pad 220. The second power terminal may be electrically connected to the first side 221 of the second die pad 220. The second power semiconductor die 210 may also comprise a control terminal 212 which may e.g. be arranged on the first side next to the first power terminal 211.

The first power terminal 111 of the first power semiconductor die 110 may be electrically connected to the second power terminal of the second power semiconductor die 210. In particular, the first power terminal 111 may be connected to the first side 221 of the second die pad 220 via a first electrical connector 230. The first electrical connector 230 may for example comprise or consist of a bond wire, a ribbon or a contact clip.

The first power terminal 211 of the second power semiconductor die 210 may be electrically connected to leads 240 via a second electrical connector 250. The leads 240 may for example be exposed from the second lateral side 162 of the encapsulation 160. The second electrical connector 250 may for example comprise or consist of a bond wire, a ribbon or a contact clip.

The first power terminal 211 of the second power semiconductor die 210 may also be electrically connected to the second external contact 170 (not shown in Fig. 2). An example of such a connection is shown in Fig. 3.

The first power terminal 211 of the second power semiconductor die 210 may also be connected to a lead 251, wherein the lead 251 is configured as a sensing contact. The control terminal 212 of the second power semiconductor die 210 may be connected to a lead 252, wherein the lead 252 is configured to receive control signals. The second die pad 220 may be designed as a monobloc part with leads 222 exposed from the second lateral side 162 of the encapsulation 160.

Figure 3 shows a further power semiconductor package 300 which may be similar or identical to the power semiconductor packages 100 and 200. In particular, the power semiconductor package 300 may comprise all components described with respect to the power semiconductor packages 100 and 200 and it may further comprise the components described in the following.

As shown in Fig. 3, the second power semiconductor die 220 may be electrically connected to the first and second passive electronic components 130, 150. For example, the power semiconductor package 300 may comprise a third external contact 310 and a third passive electronic component 320. A third electrical connector 330 (e.g. comprising a bond wire, a ribbon or a contact clip) may electrically connect the first power terminal 211 of the second power semiconductor die 210 to an internal ledge 311 of the third external contact 310.

The internal ledge 311 of the third external contact 310 is separated from the internal ledge 171 of the second external contact 170 by a third trench, wherein the third passive electronic component 320 may span the third trench.

The third external contact 310 may comprise one or more leads 312, wherein the one or more leads 312 and the internal ledge 311 are a monobloc part, in particular a leadframe part. The leads 142, 172, 312 of the first, second and third external leads 140, 170 and 310 may be arranged side-by-side and may be exposed from the same lateral side 161 of the encapsulation 160. One or more of the leads 142, 172, 312 may be configured as power contacts of the power semiconductor package 300.

The third passive electronic component 320 may be a different type or the same type of component as the first and/or second passive electronic component 130, 150. According to an example, the third passive electronic component 320 is a resistor and the first and second passive electronic components 130, 150 are capacitors.

According to an example, the third passive electronic component 320 has a bigger size than the first and/or the second passive electronic component 130, 150. The third passive electronic component 320 may for example have a footprint that is at least twice as large, or three times as large, or four times as large as a footprint of the first and/or second passive electronic component 130, 150.

Integrating the passive electronic components 130, 150 and 320 into the power semiconductor package 300 may reduce leakage inductance and/or excessive voltage spike as described further above.

As shown in Fig. 3, the internal ledge 171 of the second external contact 170 may have an L-shape which is arranged along at least part of two lateral sides of the internal ledge 141 of the first external contact 140. Furthermore, the internal ledge 311 of the third external contact 310 may also have an L-shape which is arranged along at least part of two lateral sides of the internal ledge 171 of the second external contact 170. This may be a particularly space-saving design.

The second passive electronic component 150 may e.g. be connected to a first leg and the third passive electronic component 320 may be connected to a second leg of the L-shaped internal ledge 171 of the second external contact 170. Likewise, the third electrical connector 330 may be connected to a first leg and the third passive electronic component 320 may be connected to a second leg of the L-shaped internal ledge 311 of the third external contact 310.

The internal ledges 141, 171 and 311 of the external contacts 140, 170 and 310 and the trenches separating the internal ledges may constitute a "passive electronic component section" of the power semiconductor package 300, wherein this section does not comprise any active electronic component. A footprint of this section may for example be about the size of both die pads 120, 220 combined. This passive electronic component section may be arranged along two parallel edges of the die pads 120, 220 (compare Fig. 3). By using a combination of an essentially rectangular internal ledge 141 and L-shaped internal ledges 171, 311 as for example shown in Fig. 3, the available space in the passive electronic component section may be used efficiently.

As shown in Figs. 1-3, the various leads of the power semiconductor packages 100-300 extend beyond the circumference of the encapsulation 160. In other words, the power semiconductor packages 100-300 are "leaded packages". It is however also possible that the various leads do not extend beyond the circumference of the encapsulation 160 ("leadless package").

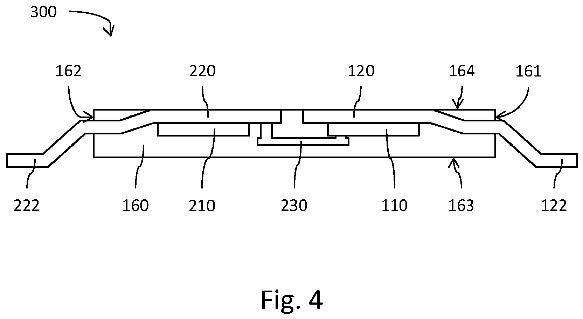

Figure 4 shows a side view of the power semiconductor package 300 according to a specific example.

As shown in Fig. 4, the encapsulation may comprise a first main side 163 and an opposite second main side 164, wherein the lateral sides 161, 162 connect the first and second main sides 163, 164. According to the example shown in Fig. 4, the die pads 120, 220 are exposed from the second main side 164, for example in order to be coupled to a heatsink. It is however also possible that the die pads 120, 220 are not exposed from the second main side 164 of the encapsulation 160. In the latter case, the power semiconductor dies and the passive electronic components may also be arranged at the side of the die pads 120, 220 that faces the second main side 164 of the encapsulation 160 (i.e. the upper side of the die pads 120, 220 in Fig. 4).

The power semiconductor package 300 may be configured to be arranged over and connected to a PCB such that the first main side 163 of the encapsulation 160 faces the PCB.

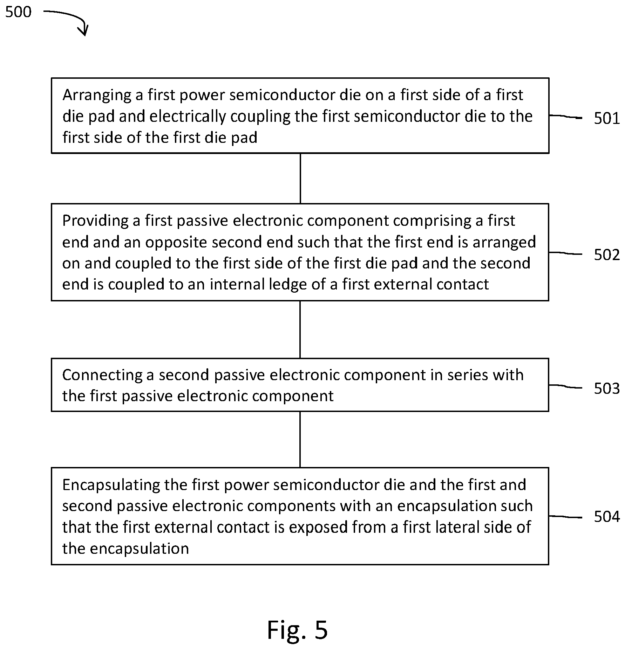

Figure 5 shows a flow chart of a method 500 for fabricating a power semiconductor package. The method 500 may for example be used to fabricate the power semiconductor packages 100-300.

The method 500 comprises at 501 a process of arranging a first power semiconductor die on a first side of a first die pad and electrically coupling the first semiconductor die to the first side of the first die pad, at 502 a process of providing a first passive electronic component comprising a first end and an opposite second end such that the first end is arranged on and coupled to the first side of the first die pad and the second end is coupled to an internal ledge of a first external contact, at 503 a process of connecting a second passive electronic component in series with the first passive electronic component, and at 504 a process of encapsulating the first power semiconductor die and the first and second passive electronic components with an encapsulation such that the first external contact is exposed from a first lateral side of the encapsulation.

### EXAMPLES

In the following, the power semiconductor package and the method for fabricating a power semiconductor package are further explained using specific examples.

Example 1 is a power semiconductor package, comprising: a first power semiconductor die arranged on and electrically coupled to a first side of a first die pad, a first passive electronic component comprising a first end and an opposite second end, wherein the first end is arranged on and coupled to the first side of the first die pad and the second end is coupled to an internal ledge of a first external contact, a second passive electronic component connected in series with the first passive electronic component, and an encapsulation encapsulating the first power semiconductor die and the first and second passive electronic components, wherein the first external contact is exposed from a first lateral side of the encapsulation.

Example 2 is the power semiconductor package of example 1, further comprising: a second power semiconductor die arranged on and electrically coupled to a second die pad, wherein the first and second power semiconductor dies are electrically connected to form a half-bridge circuit.

Example 3 is the power semiconductor package of example 2, wherein the second power semiconductor die is electrically connected to the first and second passive electronic components.

Example 4 is the power semiconductor package of one of the preceding examples, wherein the internal ledge of the first external contact is separated from the first die pad by a first trench, wherein the first passive electronic component spans the first trench.

Example 5 is the power semiconductor package of one of the preceding examples, wherein the first external contact is a power contact.

Example 6 is the power semiconductor package of one of the preceding examples, further comprising: a second external contact, wherein an internal ledge of the second external contact is separated from the internal ledge of the first external contact by a second trench, and wherein the second passive electronic component spans the second trench.

Example 7 is the power semiconductor package of example 6, wherein the internal ledge of the second external contact has an L-shape being arranged along at least part of two lateral sides of the internal ledge of the first external contact.

Example 8 is the power semiconductor package of example 6 or 7, further comprising: a third external contact, and a third passive electronic component, wherein an internal ledge of the third external contact is separated from the internal ledge of the second external contact by a third trench, and wherein the third passive electronic component spans the third trench.

Example 9 is the power semiconductor package of example 8, wherein the internal ledge of the third external contact has an L-shape being arranged along at least part of two lateral sides of the internal ledge of the second external contact.

Example 10 is the power semiconductor package of one of the preceding examples, wherein the first and second passive electronic components are capacitors.

Example 11 is the power semiconductor package of example 8 or 9, wherein the first and second passive electronic components are capacitors and the third passive electronic component is a resistor.

Example 12 is the power semiconductor package of one of the preceding examples, wherein the encapsulation comprises a molded body.

Example 13 is the power semiconductor package of one of the preceding examples, wherein the internal ledge of the first external contact has an essentially rectangular shape, and wherein a longer side of the internal ledge of the first external contact is arranged perpendicular to the first lateral side of the encapsulation.

Example 14 is a method for fabricating a power semiconductor package, the method comprising: arranging a first power semiconductor die on a first side of a first die pad and electrically coupling the first semiconductor die to the first side of the first die pad, providing a first passive electronic component comprising a first end and an opposite second end such that the first end is arranged on and coupled to the first side of the first die pad and the second end is coupled to an internal ledge of a first external contact, connecting a second passive electronic component in series with the first passive electronic component, and encapsulating the first power semiconductor die and the first and second passive electronic components with an encapsulation such that the first external contact is exposed from a first lateral side of the encapsulation.

Example 15 is the method of example 14, wherein the internal ledge of the first external contact is separated from the first die pad by a first trench, wherein the first passive electronic component spans the first trench.

Example 16 is an apparatus with means for performing the method according to example 14 or 15.

While the disclosure has been illustrated and described with respect to one or more implementations, alterations and/or modifications may be made to the illustrated examples without departing from the spirit and scope of the appended claims. In particular regard to the various functions performed by the above described components or structures (assemblies, devices, circuits, systems, etc.), the terms (including a reference to a "means") used to describe such components are intended to correspond, unless otherwise indicated, to any component or structure which performs the specified function of the described component (e.g., that is functionally equivalent), even though not structurally equivalent to the disclosed structure which performs the function in the herein illustrated exemplary implementations of the disclosure.

## Claims

1. A power semiconductor package (100), comprising:
a first power semiconductor die (110) arranged on and electrically coupled to a first side (121) of a first die pad (120),
a first passive electronic component (130) comprising a first end and an opposite second end, wherein the first end is arranged on and coupled to the first side (121) of the first die pad (120) and the second end is coupled to an internal ledge (141) of a first external contact (140),
a second passive electronic component (150) connected in series with the first passive electronic component (130), and
an encapsulation (160) encapsulating the first power semiconductor die (110) and the first and second passive electronic components (130, 150), wherein the first external contact (140) is exposed from a first lateral side (161) of the encapsulation (160).

2. The power semiconductor package (200) of claim 1, further comprising:
a second power semiconductor die (210) arranged on and electrically coupled to a second die pad (220),
wherein the first and second power semiconductor dies (110, 210) are electrically connected to form a half-bridge circuit.

3. The power semiconductor package (200) of claim 2, wherein the second power semiconductor die (210) is electrically connected to the first and second passive electronic components (130, 150).

4. The power semiconductor package (100) of one of the preceding claims, wherein the internal ledge (141) of the first external contact (140) is separated from the first die pad (120) by a first trench, wherein the first passive electronic component (130) spans the first trench.

5. The power semiconductor package (100) of one of the preceding claims, wherein the first external contact (140) is a power contact.

6. The power semiconductor package (100) of one of the preceding claims, further comprising:
a second external contact (170),
wherein an internal ledge (171) of the second external contact (170) is separated from the internal ledge (141) of the first external contact (140) by a second trench, and
wherein the second passive electronic component (150) spans the second trench.

7. The power semiconductor package (300) of claim 6, wherein the internal ledge (171) of the second external contact (170) has an L-shape being arranged along at least part of two lateral sides of the internal ledge (141) of the first external contact (140).

8. The power semiconductor package (300) of claim 6 or 7, further comprising:
a third external contact (310), and
a third passive electronic component (320),
wherein an internal ledge (311) of the third external contact (310) is separated from the internal ledge (171) of the second external contact (170) by a third trench, and
wherein the third passive electronic component (320) spans the third trench.

9. The power semiconductor package (300) of claim 8, wherein the internal ledge (311) of the third external contact (310) has an L-shape being arranged along at least part of two lateral sides of the internal ledge (171) of the second external contact (170).

10. The power semiconductor package (100) of one of the preceding claims, wherein the first and second passive electronic components (130, 150) are capacitors.

11. The power semiconductor package (300) of claim 8 or 9, wherein the first and second passive electronic components (130, 150) are capacitors and the third passive electronic component (320) is a resistor.

12. The power semiconductor package (100) of one of the preceding claims, wherein the encapsulation (160) comprises a molded body.

13. The power semiconductor package (100) of one of the preceding claims, wherein the internal ledge (141) of the first external contact (140) has an essentially rectangular shape, and
wherein a longer side of the internal ledge (141) of the first external contact (140) is arranged perpendicular to the first lateral side (161) of the encapsulation (160).

14. A method (500) for fabricating a power semiconductor package, the method comprising:
arranging (501) a first power semiconductor die on a first side of a first die pad and electrically coupling the first semiconductor die to the first side of the first die pad,
providing (502) a first passive electronic component comprising a first end and an opposite second end such that the first end is arranged on and coupled to the first side of the first die pad and the second end is coupled to an internal ledge of a first external contact,
connecting (503) a second passive electronic component in series with the first passive electronic component, and
encapsulating (504) the first power semiconductor die and the first and second passive electronic components with an encapsulation such that the first external contact is exposed from a first lateral side of the encapsulation.

15. The method (500) of claim 14, wherein the internal ledge of the first external contact is separated from the first die pad by a first trench, wherein the first passive electronic component spans the first trench.
